# EUROPÄISCHE PATENTSCHRIFT

(11) **EP 0 386 604 B1**
(45) Veröffentlichungstag und Bekanntmachung des Hinweises auf die Patenterteilung: **07.12.1994**
(21) Anmeldenummer: 90103884.4
(22) Anmeldetag: 28.02.1990
(51) Int. Cl.: G01R 21/00, G01R 21/133

(54) **Statischer Elektrizitätszähler**
Static electricity meter
Compteur électrique statique

(30) Priorität: 07.03.1989 CH 839/89; 03.11.1989 CH 3973/89
(43) Veröffentlichungstag der Anmeldung: 12.09.1990
(73) Patentinhaber: ZELLWEGER LUWA AG, CH-8610 Uster (CH)
(72) Erfinder: Konrad, Bernhard, CH-8620 Wetzikon (CH)

(56) Entgegenhaltungen:
- EP-A- 0 201 019
- EP-A- 0 266 231
- DE-A- 2 650 633
- DE-A- 2 757 595
- GB-A- 2 133 594
- US-A- 3 546 565
- US-A- 4 368 424

## Beschreibung

Die vorliegende Erfindung betrifft einen statischen Elektrizitätszähler für die Messung des Verbrauchs von elektrischer Energie, mit einem einen mit einem Luftspalt versehenen offenen Stromwandler von der Art eines nicht belasteten Transformators und eine dem Stromwandler nachgeschaltete Integrationsstufe aufweisenden Messteil und mit einem Auswerteteil.

Integratoren haben bekanntlich unter anderem die Eigenschaft, dass ihre charakteristischen Zeitkonstanten durch Temperaturänderungen und Alterung starken Schwankungen unterworfen sind. Dabei sind insbesondere die verwendeten Kondensatoren sehr kritische Elemente, deren Stabilisierung auf die geforderte Genauigkeit hohe Kosten verursacht. Somit bildet bei analogen Integratoren deren Langzeitgenauigkeit eines der wesentlichsten Probleme; und die Erfindung hat die Aufgabe, dieses Problem bei Elektrizitätszählern der eingangs genannten Art zu lösen.

Ein Elektrizitätszähler dieser Art ist aus der US-A-4,368,424 bekannt, in der hinsichtlich des genannten Problems nur erwähnt ist, dass die Möglichkeit der Kompensation von Nichtlinearitäten des Ausgangssignals durch Einsatz von Baugruppen entgegengesetzter Charakteristiken besteht.

Die gestellte Aufgabe wird erfindungsgemäss dadurch gelöst, dass der Auswerteteil einen Mikrorechner aufweist, in welchem eine Skalen-Bemessung des Ausgangssignals des Messteils unter Berücksichtigung der charakteristischen Zeitkonstanten der Integrationsstufe erfolgt, dass zur Bestimmung des Faktors für die Skalen-Bemessung an die Integrationsstufe während einer definierten Zeit eine definierte Referenzspannung einerseits bei Eichbedingungen und andererseits im Betrieb angelegt ist und daraus die Ableitung eines Referenzwerts beziehungsweise eines Kalibrierwerts für das Ausgangssignal des Messteils erfolgt, und dass der Mikrorechner zur Speicherung des Referenzwerts und zur Bestimmung des genannten Faktors für die Skalen-Bemessung anhand des Verhältnisses zwischen dem Referenz- und dem Kalibrierwert ausgebildet ist.

Auf diese Weise erfolgt die Skalen-Bemessung des Signals des Messteils unter Berücksichtigung der charakteristischen Zeitkonstante des Integrators, wodurch das Problem von dessen Langzeitgenauigkeit auf einfache Weise gelöst wird.

Eine bevorzugte Ausführungsform des erfindungsgemässen Elektrizitätszählers ist dadurch gekennzeichnet, dass der Stromwandler durch eine vom Laststrom durchflossene lineare Drosselspule und eine dieser zugeordnete Hilfswicklung gebildet ist, und dass die in der Hilfswicklung induzierte Spannung das Eingangssignal der Integrationsstufe bildet.

Im folgenden wird die Erfindung anhand von Ausführungsbeispielen und der Zeichnungen näher erläutert; es zeigt:
- Fig. 1: ein Blockschema eines ersten Ausführungsbeispiels der erfindungswesentlichen Teile eines Elektrizitätszählers;
- Fig. 2: eine Detailvariante des Blockschemas von Fig. 1;
- Fig. 3: das Beispiel von Fig. 2, etwas detaillierter;
- Fig. 4: ein Schema eines zweiten Ausführungsbeispiels; und
- Fig. 5: ein Diagramm zur Funktionserläuterung.

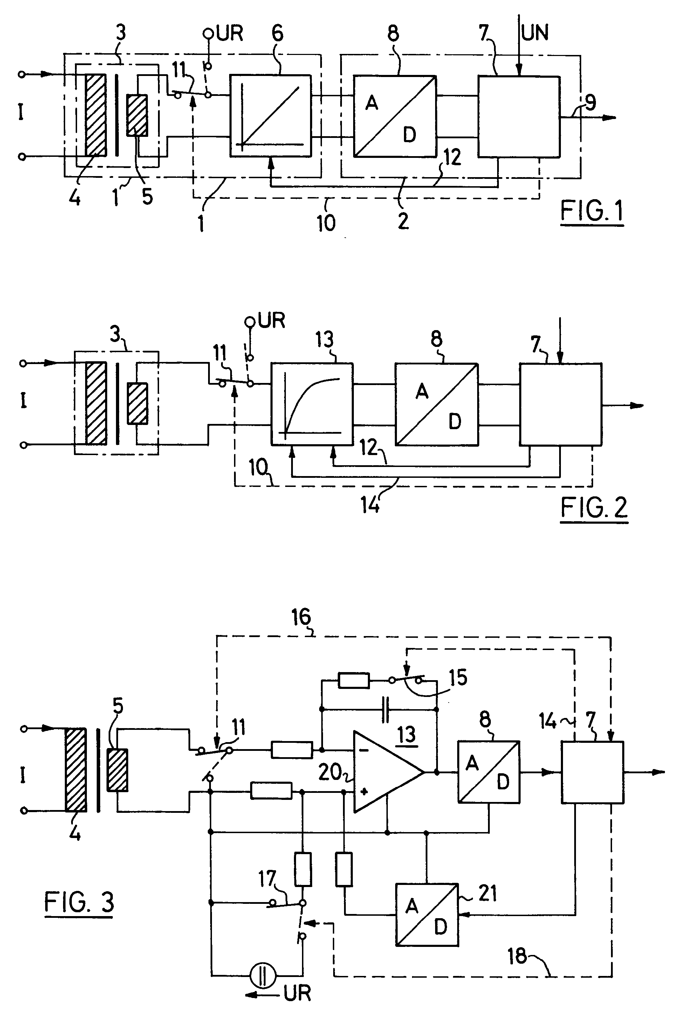

Fig. 1 zeigt einen Ausschnitt aus einem statischen Elektrizitätszähler bestehend aus einem Messteil 1 und aus einem Auswerteteil 2. Der Messteil 1 enthält einen magnetischen Stromsensor 3, mit welchem Leiterströme potentialfrei erfasst werden können. Da wegen des Gleichstromanteils im Verbraucherstrom nicht direkt mittels eines Stromwandlers gemessen werden kann, besteht der Stromsensor aus einer linearen Drosselspule 4, welche vom Laststrom I durchflossen wird, und aus einer Hilfswicklung 5, in welcher durch die Spule 4 eine Spannung induziert wird.

Die in der Hilfswicklung 5 induzierte Spannung wird einem analogen Integrator 6 zugeführt, in welchem durch Integration der genannten induzierten Spannung eine stromproportionale Spannung erzeugt wird. Diese wird als transformiertes Stromsignal weiterverarbeitet. Die eigentliche Messung erfolgt in einem Mikrorechner 7 mit vorgeschaltetem Analog/ Digital-Wandler 8. Am Ausgang 9 des Mikrorechners 7 ist somit ein Stromsignal oder eine davon abgeleitete Grösse, wie Energie oder Leistung, erhältlich. Mit UN ist die dem Mikrorechner 7 zugeführte Lastspannung bezeichnet.

In der EP-A-0 201 019 ist ein statischer Elektrizitätszähler mit einem elektronischen Messwerk beschrieben, welcher einen Mikrorechner für die Signalverarbeitung unter Berücksichtigung von Korrekturwerten für die verschiedenen Elemente der Schaltung aufweist. Dabei stellen die Korrekturwerte jeweils einen integralen Wert für den betreffenden Messbereich dar und sind in im Zähler gespeicherten Zählerkenngrössen enthalten, von denen jede einen einer definierten Energiemenge entsprechenden Zahlenwert repräsentiert. Auf die Offenbarung dieser EP-A wird hiermit ausdrücklich Bezug genommen.

Der in Fig. 1 der vorliegenden Patentanmeldung dargestellte Messteil 1 mit dem Stromsensor 3 und dem Integrator 6 würde bei dem bekannten Elektrizitätszähler nach der EP-A-0 201 109 Bestandteil von dessen Eingangsmodul 1 (Fig. 1) bilden, die Funktion des Mikrorechners 7 würde vorzugsweise vom Microcomputer 8 (Fig. 1) dieses bekannten Elektrizitätszähler übernommen.

Wie schon erwähnt wurde, sind die charakteristischen Zeitkonstanten von analogen Integratoren von der Art des Integrators 6 starken Schwankungen unterworfen, welche durch Temperaturänderungen und Alterung verursacht sind. Daher können derartige Integratoren nur dann sinnvoll in der Praxis eingesetzt werden, wenn ihre charakteristischen Zeitkonstanten in den erforderlichen Abständen überprüft werden und wenn dafür Sorge getragen ist, dass etwaige Aenderungen und Schwankungen das Messergebnis nicht verfälschen können. Ueblicherweise würde letzteres durch eine entsprechende Nachregelung des Integrators erfolgen; beim vorliegenden Elektrizitätszähler wird dafür der folgende Weg vorgeschlagen:

Es wird im Betrieb des Elektrizitätszählers die Integratorzeitkonstante gemessen und zur Skalierung, das heisst, zur Skalen-Bemessung oder Skalen-Gewichtung des Stromsignals oder der von diesem abgeleiteten Grösse, wie beispielsweise Energie oder Leistung, verwendet. Das bedeutet mit anderen Worten, dass der Mikrorechner 7 bei der Berechnung der verbrauchten Energie aus dem Uebertragungswert des ihm zugeführten Signals diesen Uebertragungswert mit einem anhand der Messung der Integrationszeitkonstante gewonnenen "Skalierungsfaktor" multipliziert und dadurch etwaige Schwankungen der Integratorzeitkonstante ausgleicht. Es findet also im Betrieb des Elektrizitätszählers eine fortwährende Selbstkalibrierung statt.

Diese Selbstkalibrierung erfolgt in der Praxis dadurch, dass von einer geeigneten Steuerung, vorzugsweise durch den Mikrorechner 7, einerseits via eine Leitung 10 ein Schalter 11 von der voll ausgezogenen in die gestrichelt eingezeichnete Stellung umgeschaltet, und andererseits (Leitung 12) der Ausgang des Integrators 6 auf Null gesetzt wird. Durch die Betätigung des Schalters 11 wird an den Eingang des Integrators 6 anstatt der induzierten Spannung der Hilfswicklung 5 eine Referenz-Gleichspannung UR angelegt, wodurch die Spannung am Integratorausgang rampenförmig ansteigt. Nach einer definierten Zeit wird diese Spannung gemessen und dadurch ein Kalibrierwert gewonnen, wobei eventuell zur Ausschaltung von Störungen mehrere Messungen mit Mittelwertbildung durchgeführt werden können. Nun wird der Kalibrierwert mit einem unter Eichbedingungen auf gleiche Weise gemessenen und archivierten, im Mikrorechner 7 gespeicherten, Referenzwert verglichen. Dieser Vergleich ergibt unmittelbar den schon genannten Skalierungsfaktor.

Der beschriebene Kalibrierungsvorgang wird vom Mikrorechner 7 in grösseren Abständen von beispielsweise Tagen oder Wochen selbst ausgelöst. Er beträgt jeweils nur wenige Sekunden, so dass der Betrieb des Elektrizitätszählers nicht beeinträchtigt wird.

Bei der in den Figuren 2 und 3 dargestellten Variante wird statt eines idealen Integrators 6 ein Tiefpass 13 mit tiefer Grenzfrequenz verwendet. Dies entschärft die Probleme, die aus eventuellen Eingangs-Fehlspannungen des Verstärker-Elements im Integrator resultieren können. Allerdings muss der Tiefpass 13 für den Kalibriervorgang als idealer Integrator beschaltet werden, was durch Oeffnen eines über eine Steuerleitung 14 betätigbaren Schalters 15 (Fig. 3) erfolgt. Die anderen Vorgänge bei der Kalibrierung verlaufen ähnlich wie schon beschrieben: Abschalten des Tiefpasses 13 von der Hilfswicklung 5 via Schalter 11 und Steuerleitung 16 (Fig. 3), und Anlegen der Referenzspannung UR via Schalter 17 und Steuerleitung 18.

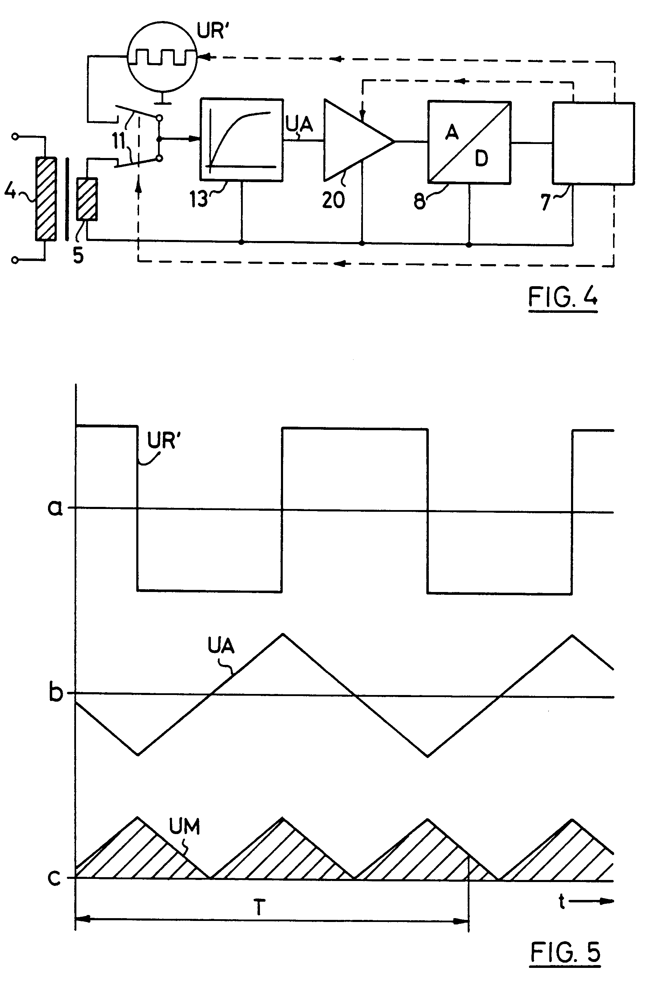

Eine andere Variante besteht darin, für die Kalibrierung als Referenzspannung anstatt einer Gleichspannung UR eine Wechselspannung UR′ zu verwenden. Diese Variante ist in den Figuren 4 und 5 dargestellt. Wie auch bei den anderen Ausführungsbeispielen wird durch Umlegen des Schalters 11 das reguläre Eingangssignal vom Eingang des Tiefpasses 13 abgetrennt und statt dessen die Referenz-Wechselspannung UR′ angelegt (vgl. Fig. 5, Zeile a); am Ausgang des Tiefpasses 13 wird eine Wechselspannung UA erzeugt (Fig. 5, Zeile b), deren Effektivwert, oder vorteilhafter, deren gleichgerichteter Mittelwert UM (Fig. 5, Zeile c) über eine bestimmte Zeitdauer T gemessen wird. Ein Vergleich des Ergebnisses dieser Messung mit einem auf gleiche Art bei der Eichung gemessenen und archivierten Referenzwert liefert einen Wert, der der Aenderung der Messkonstante des Messteils direkt proportional ist. Messteil bezeichnet hier in Analogie zu Fig. 1 den aus Drosselspule 4 mit Hilfswicklung 5 (Stromsensor 3) und aus dem Tiefpass 13 bestehenden Strom-Messkreis. Mit Messkonstante ist das Amplitudenverhältnis zwischen Aus- und Eingangsspannung am Tiefpass 13 bezeichnet.

Zur Verringerung des Schaltungsaufwands kann als Referenz-Wechselspannung UR′ die ohnehin vorhandene Referenz-Gleichspannung des Analog/Digital-Wandlers 8 verwendet werden, indem diese mittels Analog-Schaltern abwechselnd positiv und negativ an den Eingang des Tiefpasses 13 angelegt wird.

## Patentansprüche

1. Statischer Elektrizitätszähler für die Messung des Verbrauchs von elektrischer Energie, mit einem einen mit einem Luftspalt versehenen offenen Stromwandler (3) von der Art eines nicht belasteten Transformators und eine dem Stromwandler (3) nachgeschaltete Integrationsstufe (6, 13) aufweisenden Messteil (1) und mit einem Auswerteteil (2), dadurch gekennzeichnet, dass der Auswerteteil (2) einen Mikrorechner (7) aufweist, in welchem eine Skalen-Bemessung des Ausgangssignals des Messteils (1) unter Berücksichtigung der charakteristischen Zeitkonstanten der Integrationsstufe (6, 13) erfolgt, dass zur Bestimmung des Faktors für die Skalen-Bemessung an die Integrationsstufe (6, 13) während einer definierten Zeit eine definierte Referenzspannung (UR, UR′) einerseits bei Eichbedingungen und andererseits im Betrieb angelegt ist und daraus die Ableitung eines Referenzwerts beziehungsweise eines Kalibrierwerts für das Ausgangssignal des Messteils (1) erfolgt, und dass der Mikrorechner (7) zur Speicherung des Referenzwerts und zur Bestimmung des genannten Faktors für die Skalen-Bemessung anhand des Verhältnisses zwischen dem Referenz- und dem Kalibrierwert ausgebildet ist.

2. Elektrizitätszähler nach Anspruch 1, dadurch gekennzeichnet, dass der Stromwandler (3) durch eine vom Laststrom durchflossene, lineare Drosselspule (4) und eine dieser zugeordnete Hilfswicklung (5) gebildet ist, und dass die in der Hilfswicklung induzierte Spannung das Eingangssignal der Integrationsstufe (6, 13) bildet.

3. Elektrizitätszähler nach Anspruch 2, dadurch gekennzeichnet, dass die Referenzspannung durch eine Gleichspannung (UR) gebildet ist.

4. Elektizitätszähler nach Anspruch 2, dadurch gekennzeichnet, dass die Referenzspannung durch eine Wechselspannung (UR′) gebildet ist, und dass zur Ermittlung des Referenz- und des Kalibrierwerts am Ausgang des Messteils (1) der Effektivwert oder der gleichgerichtete Mittelwert (UM) des Ausgangssignals gemessen wird.

5. Elektrizitätszähler nach Anspruch 4, dadurch gekennzeichnet, dass als Referenz-Wechselspannung (UR′) die Referenz-Gleichspannung eines dem Mikrorechner (7) vorgeschalteten Analog/Digitalwandlers (8) verwendet wird, welche abwechselnd positiv und negativ an den Eingang der Integrationsstufe (13) gelegt wird.

6. Elektrizitätszähler nach einem der Ansprüche 1 bis 5, dadurch gekennzeichnet, dass die Integrationsstufe durch einen idealen Integrator (6) mit Operationsverstärker gebildet ist.

7. Elektrizitätszähler nach einem der Ansprüche 1 bis 5, dadurch gekennzeichnet, dass die Integrationsstufe durch ein RC-Glied, vorzugsweise durch einen Tiefpass (13), gebildet ist.

8. Elektrizitätszähler nach Anspruch 7, dadurch gekennzeichnet, dass der Tiefpass (13) für den Kalibriervorgang als idealer Integrator beschaltet ist.

## Claims

1. Static electricity meter for measuring the consumption of electric energy, with a measuring part (1) having an open current transformer (3), which has an air gap and is of the unloaded transformer type, and an integration stage (6, 13) connected downstream of the current transformer (3), and with an evaluating part (2), characterized in that the evaluating part (2) has a microcomputer (7), in which a scale dimensioning of the output signal of the measuring part (1) is performed with allowance made for the characteristic time constant of the integration stage (6, 13), in that for determining the factor for the scale dimensioning there is applied to the integration stage (6, 13) during a defined time a defined reference voltage (UR, UR′) on the one hand under calibrating conditions and on the other hand during operation and, from this, the derivation of a reference value or of a calibration value for the output signal of the measuring part (1) is performed, and in that the microcomputer (7) is designed for storage of the reference value and for determination of the said factor for the scale dimensioning on the basis of the ratio between the reference value and the calibration value.

2. Electricity meter according to Claim 1, characterized in that the current transformer (3) is formed by a linear reactance coil (4), through which the load current flows, and an auxiliary winding (5) assigned to the said reactance coil, and in that the voltage induced in the auxiliary winding forms the input signal of the integration stage (6, 13).

3. Electricity meter according to Claim 2, characterized in that the reference voltage is formed by a direct voltage (UR).

4. Electricity meter according to Claim 2, characterized in that the reference voltage is formed by an alternating voltage (UR′), and in that, for determining the reference value and the calibration value, the effective value or the rectified average value (UM) of the output signal is measured at the output of the measuring part (1).

5. Electricity meter according to Claim 4, characterized in that the reference direct voltage of an analog/digital converter (8) connected upstream of the microcomputer (7) is used as the reference alternating voltage (UR′), which reference voltage is alternately applied positively and negatively to the input of the integration stage (13).

6. Electricity meter according to one of Claims 1 to 5, characterized in that the integration stage is formed by an ideal integrator (6) with operational amplifier.

7. Electricity meter according to one of Claims 1 to 5, characterized in that the integration stage is formed by an RC element, preferably by a low-pass filter (13).

8. Electricity meter according to Claim 7, characterized in that, for the calibration operation, the low-pass filter (13) is wired as an ideal integrator.

## Revendications

1. Compteur électrique statique pour la mesure de la consommation d'énergie électrique, comprenant une partie de mesure (1) comportant un transformateur du courant (3) ouvert et pourvu d'un entrefer, du type d'un transformateur non chargé, et un étage d'intégration (6, 13) disposé en aval du transformateur du courant (3), et une partie d'exploitation (2), caractérisé en ce que la partie d'exploitation (2) comprend un micro-calculateur (7) dans lequel est effectué un dimensionnement d'échelle du signal de sortie de la partie de mesure (1) en tenant compte de la constante de temps caractéristique de l'étage d'intégration (6, 13), et que pour la détermination du facteur de dimensionnement d'échelle une tension de référence définie (UR, UR′) est appliquée pendant une durée de temps déterminée, d'une part, lors des conditions de calibrage et, d'autre part, en mode de fonctionnement, et d'après cela est établie une valeur de référence ou une valeur de calibrage pour le signal de sortie de la partie de mesure (1), et que le micro-calculateur (7) est configuré pour le stockage de la valeur de référence et pour la détermination du facteur précité pour le dimensionnement d'échelle, à l'aide de rapports entre les valeurs de référence et de calibrage.

2. Compteur électrique selon la revendication 1, caractérisé en ce que le transformateur du courant (3) est formé par une bobine de self linéaire (4), parcourue par le courant de charge et un enroulement auxiliaire (5) associé à celle-ci, et que la tension induite dans l'enroulement auxiliaire forme le signal d'entrée de l'étage d'intégration (6, 13).

3. Compteur électrique selon la revendication 2, caractérisé en ce que la tension de référence est formée par une tension continue (UR).

4. Compteur électrique selon la revendication 2, caractérisé en ce que la tension de référence est formée par une tension alternative (UR′), et que, pour déterminer la valeur de référence et la valeur de calibrage, on mesure à la sortie de la partie de mesure (1) la valeur effective et la valeur moyenne redressée (UM) du signal de sortie.

5. Compteur électrique selon la revendication 4, caractérisé en ce qu'à titre de tension alternative de référence (UR′) est utilisée la tension continue de référence d'un convertisseur analogique/numérique (8) disposé en avant du micro-calculateur (7), qui est appliquée alternativement à polarité positive et négative, à l'entrée de l'étage d'intégration (13).

6. Compteur électrique selon l'une des revendications 1 à 5, caractérisé en ce que l'étage d'intégration est formé par un intégrateur idéal (6) avec un amplificateur opérationnel.

7. Compteur électrique selon l'une des revendications 1 à 5, caractérisé en ce que l'étage d'intégration est formé par un élément RC, de préférence par un passe-bas (13).

8. Compteur électrique selon la revendication 7, caractérisé en ce que le passe-bas (13) est monté, pour un processus de calibrage, comme intégrateur idéal.
